# EUROPEAN PATENT SPECIFICATION

(11) **EP 2 364 462 B1**
(45) Date of publication and mention of the grant of the patent: **22.07.2015**
(21) Application number: 09783782.7
(22) Date of filing: 06.10.2009
(51) Int. Cl.: G03F 7/00

(54) **IMPRINT LITHOGRAPHY APPARATUS AND METHOD**
PRÄGELITHOGRAFIE -GERÄT UND -VERFAHREN
APPAREIL ET PROCÉDÉ DE LITHOGRAPHIE PAR IMPRESSION

(30) Priority: 04.12.2008 US 193509 P
(43) Date of publication of application: 14.09.2011
(73) Proprietor: ASML Netherlands B.V., 5504 DR Veldhoven (NL); Koninklijke Philips N.V., 5656 AE Eindhoven (NL)
(72) Inventor: VAN DER TEMPEL, Leendert, NL-5565 HZ Eindhoven (NL); DIJKSMAN, Johan, NL-6002 VM Weert (NL); WUISTER, Sander, NL-5627 CW Eindhoven (NL); KRUIJT-STEGEMAN, Yvonne, NL-5642 RL Eindhoven (NL); LAMMERS, Jeroen, NL-5646 AD Eindhoven (NL); MUTSAERS, Cornelis, NL- 5508 JB Veldhoven (NL)
(74) Representative: Broeken, Petrus Henricus Johannes
(86) International application number: PCT/EP2009/062963
(87) International publication number: WO 2010/063504

(56) References cited:
- WO-A1-2007/046772
- WO-A1-2009/067241
- US-A1- 2009 140 458
- US-B1- 6 407 006
- US-B1- 6 818 139

## Description

### CROSS-REFERENCE TO RELATED APPLICATIONS

This application claims the benefit of US provisional application 61/193,509, which was filed on 4 December 2008. .

### FIELD

The present invention relates to an imprint lithography apparatus and a method for manufacture of devices, such as electronic devices and integrated circuits or other applications, such as the manufacture of integrated optical systems, guidance and detection patterns for magnetic domain memories, flat-panel displays, liquid-crystal displays (LCDs), thin film magnetic heads, etc.

### BACKGROUND

In lithography, there is an ongoing desire to reduce the size of features in a lithographic pattern in order to increase the density of features on a given substrate area. In photolithography, the push for smaller features has resulted in the development of technologies such as immersion lithography and extreme ultraviolet (EUV) lithography, which are however rather costly.

A potentially less costly road to smaller features that has gained increasing interest is so-called imprint lithography, which generally involves the use of a "stamp" (often referred to as an imprint template) to transfer a pattern onto a substrate. An advantage of imprint lithography is that the resolution of the features is not limited by, for example, the emission wavelength of a radiation source or the numerical aperture of a projection system. Instead, the resolution is mainly limited to the pattern density on the imprint template.

Lithography typically involves applying several patterns onto a substrate, the patterns being stacked on top of one another such that together they form a device such as an integrated circuit. Alignment of each pattern with a previously provided pattern is an important consideration. If patterns are not aligned with each other sufficiently accurately, then this may result in some electrical connections between layers not being made. This, in turn, may cause the device to be non-functional. A lithographic apparatus therefore usually includes an alignment apparatus, which may be used to align each pattern with a previously provided pattern, and/or with alignment marks provided on the substrate.

Typically, the substrate is clamped to a substrate holder and the substrate holder and/or imprint template (or imprint templates) is moveable relative to the other between imprints. Generally, a control system, such as a computer running a computer program, uses information from the alignment apparatus to control the positions of the substrate and/or the imprint template(s) relative to the other as each pattern is imprinted. In this specification, the term "substrate" is meant to include any surface layer forming part of the substrate, such as a planarization layer or an anti-reflection coating layer.

WO2009067241A1 discloses an imprint lithography template or imprinting stack including a porous material defining a multiplicity of pores with an average pore size of at least about 0.4 nm. A porosity of the porous material is at least about 10%. The porous template, the porous imprinting stack, or both may be used in an imprint lithography process to facilitate diffusion of gas trapped between the template and the imprinting stack into the template, the imprinting stack or both, such that polymerizable material between the imprinting stack and the template rapidly forms a substantially continuous layer between the imprinting stack and the template.

### SUMMARY

Imprint lithography involves the patterning of an imprintable medium on a surface of a substrate to be patterned. The patterning may involve contacting a patterned surface of an imprint template with a layer of imprintable medium such that the imprintable medium flows into recesses in the patterned surface and is pushed aside by protrusions on the patterned surface. The recesses define pattern features of the patterned surface of the imprint template. Typically, the imprintable medium is flowable as the patterned surface and the imprintable medium contact each other. Following patterning of the imprintable medium, the imprintable medium is suitably brought into a non- flowable (or frozen state) and the patterned surface of the imprint template and the patterned imprintable medium are separated. The substrate and patterned imprintable medium are then typically processed further in order to pattern the substrate. The imprintable medium is typically formed from imprintable medium droplets on the surface of a substrate to be patterned.

A patterning distortion in a patterned imprintable medium may arise due to a gas pocket trapped between a patterning surface of the imprint template, and/or the substrate and/or the flowable, imprintable medium. For example, a gas pocket trapped between an imprint template and an imprintable, flowable medium, such as a resist, on a substrate, may lead to an irregularity once the imprintable medium has set and so sufficient time for gas to diffuse/dissolve into or escape from the imprintable medium, substrate or imprint template must conventionally be allowed before the imprintable medium is set. This may lead to the time for gas dissolution/diffusion or escape being a rate-determining step in an imprint cycle. An embodiment of the invention relates to a method and apparatus to speed gas escape or dissolution/diffusion.

A highly diffusive gas, such as helium, may be used as an atmosphere in which imprinting takes place. Any trapped gas pocket may then be dissolved or diffused more rapidly into the imprintable medium, the substrate or the imprint template. However, a problem arising from this approach is that diffusion and/or dissolution of gas is a relatively slow process, even when a gas such as helium is used. This may lead to the need to hold the imprint template and the imprintable medium together for several seconds, tens of seconds or even minutes in order to reduce gas pocket distortions to the patterning. This, in turn, may lead to reduction in throughput for an imprint lithography process, as the diffusion time may be the rate-determining step preventing early separation of imprint template and patterned imprintable medium. This means that the time for compression molding of the imprintable medium, such as resist droplets, becomes a rate-determining step in an imprint cycle. Hence there is a need, for example, for a method and apparatus to overcome such problems or other problem in the art.

Thus, in an embodiment, an aim, amongst others, is to provide an imprint lithography method and apparatus that allows more rapid separation of imprint template and patterned imprintable medium without a trapped gas pocket.

In an aspect, there is provided a method for patterning an imprintable medium according to claim 1.

The following features are applicable to all the various aspects of the method and apparatus where appropriate. When suitable, combinations of the following features may be employed as part of the method and apparatus.

The gas used as an atmosphere is typically helium in order to provide good diffusion rates, but another suitable gas may be used. The gas may be a mixture of gases and may include a vapor in addition to gas. For instance, vapor from imprintable medium may be part or all of the gas.

Suitably, the void space is in diffusive and/or fluid connection with the patterned surface such that gas trapped between the imprintable medium and the patterned surface may readily transfer into the void space. By fluid connection is meant direct fluid connection such that viscous flow of the gas into the void space may occur. Suitably, the void space is configured such that the imprintable medium will not flow into the void space, for instance by use of a small pore size. By diffusive connection is meant that the gas may have to pass a physical barrier between the void space and the patterning recess by diffusing across that barrier. In this specification, diffusive connection means that the flux of gas across such a barrier is adequate for at least 50% by mass of trapped gas to pass through the barrier to the void space within 10 seconds. Suitably, the physical barrier may be a layer of porous, such as nanoporous material, for instance having a thickness of 1 to 10 µm. A solid layer having a thickness less than 1 µm would also be a suitable physical barrier, and could be combined with a porous barrier.

The trapped gas, after escape into the void space, may be, for example, retained within the void space, or may if the void space is in diffusive or fluid connection with the atmosphere in which imprinting takes place, escape into that atmosphere. The void space may be, for instance, in connection with a fluidic or microfluidic channel that permits the gas to escape.

The imprintable medium may be sufficiently viscous that it maintains its shape for hardening after separating the patterned surface and the imprintable medium, but typically, the imprintable medium is hardened prior to separating the patterned surface and the imprintable medium. For instance, this may be achieved by heating the imprintable medium in order to give cross-linking, or in the case of a thermoplastic imprintable medium, the medium may be cooled to transform it into a solid state (for instance to a temperature below its glass temperature) prior to separation of the imprintable medium and the patterned surface of the imprint template.

The imprint template may comprise the void space. In particular, the void space may be a void space of a porous solid medium. The porous solid medium may have an open pore structure, meaning that the pores are interconnected as the continuous phase of the medium, or may have a closed pore structure, meaning that the pores form a discontinuous phase in the medium, with the solid as the continuous phase.

Suitably, the imprint template may comprise a layer of porous solid medium whose pore space acts as the void space or both as the void space and as a diffusive connection to the patterned surface. The layer of porous solid medium may be used to form patterning features of the patterned surface of the imprint template. For instance, it may form the ends (usually the tops) of recesses in the patterned surface. The layer of porous solid medium may form the entire patterned surface of the imprint template, with both recesses and protrusions being formed from the porous solid medium.

Suitably, the porous solid medium may be a region within the imprint template having a void space configured to be in diffusive and/or fluid connection with the trapped gas.

Typically, the layer of solid porous medium may have a thickness from 1 to 10 µm, desirably from 3 to 8 µm such as approximately 5 µm. The porosity of the solid porous medium may be from 0.1 to 50% by volume, but is suitably from 0.3 to 20%, such as about 0.5% to 10%, for instance about 1%.

The solid porous medium may suitably be a nanoporous medium, by which it is meant that the pore diameter is typically less than 100 nm, for instance from about 0.1 to 20 nm, from about 0.2 nm to 10 nm, or from about 0.5 nm to 5 nm. This is suitably measured, for instance, by electron microscopy.

Suitably, the porous solid medium is selected from the group consisting of silica, silicon nitride, titania, tin oxide, zirconia, alumina tantalum oxide, and any mixture thereof. In particular, the porous solid medium may comprise or consist essentially of a silica, optionally a nanoporous silica.

The imprintable medium may be hardened by actinic radiation, such as ultraviolet (UV) radiation, applied through the imprint template. In order to facilitate this, the porous solid medium may be transmissive (i.e. transparent or translucent) to actinic radiation such as UV radiation. Silica is useful for this purpose.

Alternatively, or additionally to the imprint template, the substrate to be patterned may comprise a void space. For instance, a void space may be a void space of a layer of porous solid medium forming part of the substrate. Suitably, the layer of porous solid medium forms a surface of the substrate in contact with the imprintable medium on the surface of the substrate to be patterned.

In an aspect, there is provided an apparatus for imprint lithography of a substrate according to claim 7.

The features of the method are also applicable, where appropriate, to the apparatus. When suitable, combinations of the features may be employed as part of the apparatus, for instance as set out in the claims.

In an aspect, there is provided an imprint template for imprint lithography of a substrate according to claim 10.

The features mentioned above for the method and apparatus are also applicable, where appropriate, to the imprint template. When suitable, combinations of the features may be employed as part of the imprint template.

Suitably, the imprint template may comprise a layer of porous solid medium whose pore space acts as the void space or both as the void space and as a diffusive connection to the patterned surface. The layer of porous solid medium may be used to form patterning features of the patterned surface of the imprint template. For instance, it may form the ends (usually the tops) of recesses in the patterned surface. The layer of porous solid medium may form the entire patterned surface of the imprint template, with both recesses and protrusions being formed from the porous solid medium.

Suitably, the porous solid medium may be a region within the imprint template having a void space configured to be in diffusive and/or fluid connection with trapped gas.

Typically, the layer of solid porous medium may have a thickness from 1 to 10 µm, desirably from 3 to 8 µm such as approximately 5 µm.

The solid porous medium may suitably be a nanoporous medium, by which it is meant that the pore diameter is typically less than 100 nm, for instance from about 0.1 to 20 nm, from about 0.2 nm to 10 nm, or from about 0.5 nm to 5 nm. This is suitably measured, for instance, by electron microscopy.

Suitably, the porous solid medium is selected from the group consisting of silica, silicon nitride, titania, tin oxide, zirconia, alumina tantalum oxide, and any mixture thereof. In particular, the porous solid medium may comprises or a silica, optionally a nanoporous silica.

In order to aid release of the patterned surface from the imprintable medium after patterning, the patterned surface may comprise a release layer comprising or consisting essentially of titania, alumina, tantalum oxide, or any mixture thereof.

Further embodiments provide methods for manufacturing an imprint template, the imprint template comprising a layer of porous solid medium whose pore space acts as the void space or both as the void space and as a diffusive connection to the patterned surface. In one such embodiment, the layer of porous solid medium may be formed by a plasma deposition process. Such a plasma deposition process, for instance, plasma CVD process, is disclosed in European patent application publication no. EP-A- 1037276.

In another embodiment, the layer of porous solid medium may be formed by a spin- on-glass process, for instance as disclosed in PCT patent application publication no. WO 2004/101840. In another embodiment, the layer of porous solid medium may be formed by a sol-gel deposition process. Such a process is disclosed, for instance, in French patent application publication no. FR2762097.

For this embodiment, the porous solid medium may be patterned as a gel, when in its gel state, by pressing a master template and the gel together prior to solidification of the gel. Such a process enables a family of patterned surfaces (daughters) to be manufactured from a single parent or master template and so increases production efficiency.

For these embodiments, the porous solid medium may be as described hereinbefore. Particularly, it may comprise or consists essentially of silica, optionally nanoporous silica.

A further embodiment provides a substrate adapted to be patterned by imprint lithography, the substrate comprising a void space in diffusive and/or fluid connection with a surface of the substrate adapted to be patterned.

The void space may be a void space of a layer of porous solid medium on the surface of the substrate adapted to be patterned. The porous solid medium may be as described hereinbefore, in particular it may comprise or consist essentially of silica, such as a nanoporous silica. The porous layer may be formed using a process as detailed hereinbefore.

Such a layer of porous solid medium may also act as a bottom anti-reflective coating (BARC) on the surface of the substrate adapted to be patterned, to also prevent reflection ofUV from the substrate during hardening (for instance to avoid interference patterns forming in the imprintable medium).

The apparatus and method are particularly useful for manufacture of devices, such as electronic devices and integrated circuits or other applications, such as the manufacture of integrated optical systems, guidance and detection patterns for magnetic domain memories, flat-panel displays, liquid-crystal displays (LCDs), thin film magnetic heads, etc. In particular, the method and apparatus are suitable for high resolution lithography, where features patterned onto a substrate have a feature width or critical dimension of about 1 µm or less, typically 100 nm or less or even 10 nm or less.

### BRIEF DESCRIPTION OF THE DRAWINGS

Specific embodiments of the invention will be described with reference to the accompanying figures, in which:
Figures 1a-b schematically show examples of, respectively, hot imprint, and UV imprint lithography,
Figure 2 schematically shows the trapping of a gas pocket in UV imprint lithography,
Figure 3 shows schematically an imprint template according to an embodiment of the invention,
Figure 4 shows schematically an imprint template according to an embodiment of the invention,
Figure 5 shows schematically an imprint template according to an embodiment of the invention,
Figure 6 shows schematically an imprint template according to an embodiment of the invention, and
Figure 7 shows schematically a substrate according to an embodiment of the invention.

### DETAILED DESCRIPTION

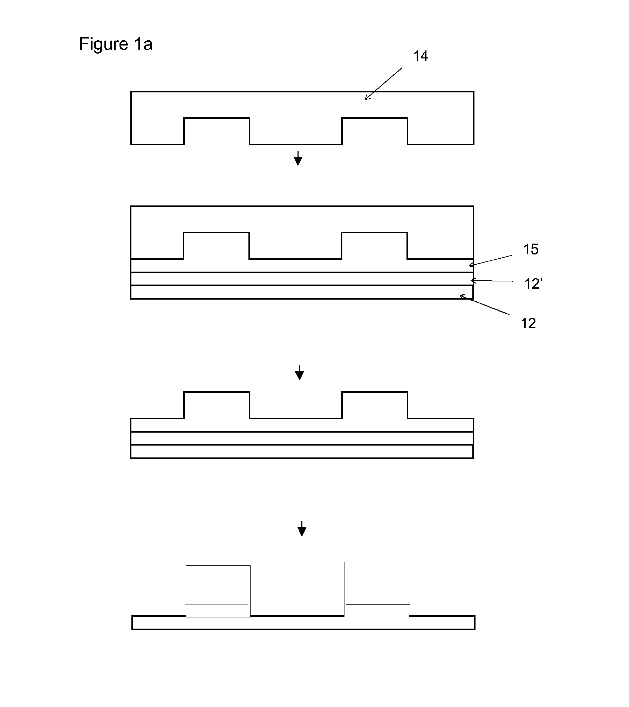

Examples of two approaches to imprint lithography are schematically depicted in Figures 1a to 1b.

Figure 1a shows an example of so-called hot imprint lithography (or hot embossing). In a typical hot imprint process, a template 14 is imprinted into a thermosetting or a thermoplastic imprintable medium 15, which has been cast on the surface of a substrate 12. The imprintable medium 15 may be, for example, resin. The resin may be, for instance, spin coated and baked onto the substrate surface or, as in the example illustrated, onto a planarization and transfer layer of the substrate 12'. When a thermosetting polymer resin is used, the resin is heated to a temperature such that, upon contact with the template, the resin is sufficiently flowable to flow into the pattern features defined on the template. The temperature of the resin is then increased to thermally cure (crosslink) the resin so that it solidifies and irreversibly adopts the desired pattern. The template 14 may then be removed and the patterned resin cooled. In hot imprint lithography employing a layer of thermoplastic polymer resin, the thermoplastic resin is heated so that it is in a freely flowable state immediately prior to imprinting with the template 14. It may be necessary to heat a thermoplastic resin to a temperature considerably above the glass transition temperature of the resin. The template is contact with the flowable resin and then cooled to below its glass transition temperature with the template 14 in place to harden the pattern. Thereafter, the template 14 is removed. The pattern will consist of the features in relief from a residual layer of the imprintable material which may then be removed by an appropriate etch process to leave only the pattern features. Examples of thermoplastic polymer resins used in hot imprint lithography processes are poly (methyl methacrylate), polystyrene, poly (benzyl methacrylate) or poly (cyclohexyl methacrylate). For more information on hot imprint, see e.g. United States patent nos. 4731155 and 5772905.

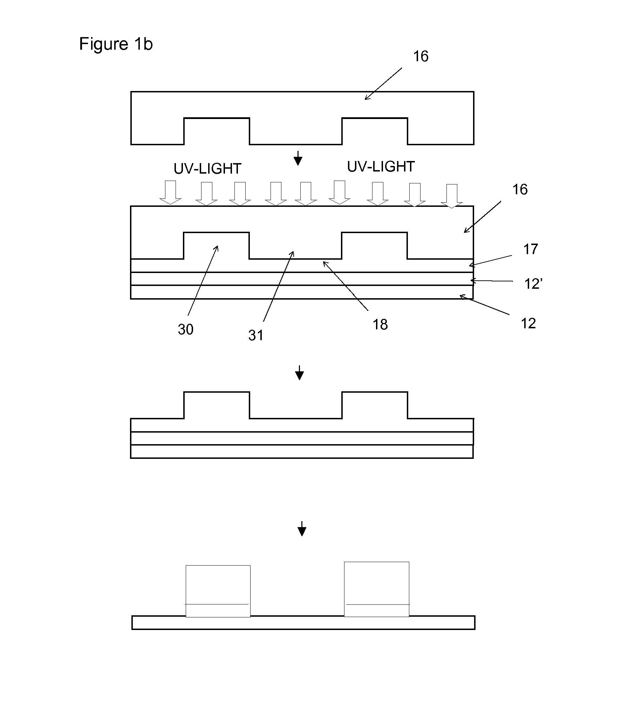

Figure 1b shows an example of UV imprint lithography, which involves the use of a transparent or translucent template which is transmissive to UV and a UV-curable liquid as imprintable medium (the term "UV" is used here for convenience but should be interpreted as including any suitable actinic radiation for curing the imprintable medium). A UV curable liquid is often less viscous than the thermosetting or thermoplastic resin used in hot imprint lithography and consequently may move much faster to fill template pattern features. A quartz template 16 is applied to a UV-curable resin 17 in a similar manner to the process of Figure 1a. However, instead of using heat or temperature cycling as in hot imprint, the pattern is frozen by curing the imprintable medium with UV radiation that is applied through the quartz template onto the imprintable medium. After removal of the template, the pattern will consist of the features in relief from a residual layer of the imprintable material which may then be removed by an appropriate etch process to leave only the pattern features. A particular manner of patterning a substrate through UV imprint lithography is so-called step and flash imprint lithography (SFIL), which may be used to pattern a substrate in small steps in a similar manner to an optical stepper conventionally used in IC manufacture. For more information on UV imprint, see e.g. United States published patent application no. 2004-0124566, United States patent no. 6334960, PCT patent application publication no. WO 02/067055, and the article by J. Haisma entitled "Mold-assisted nanolithography: A process for reliable pattern replication", J. Vac. Sci. Technol. B14(6), Nov/Dec 1996.

Combinations of the above imprint techniques are possible. See, e.g., United States patent application publication no. 2005-0274693, which mentions a combination of heating and UV curing an imprintable medium.

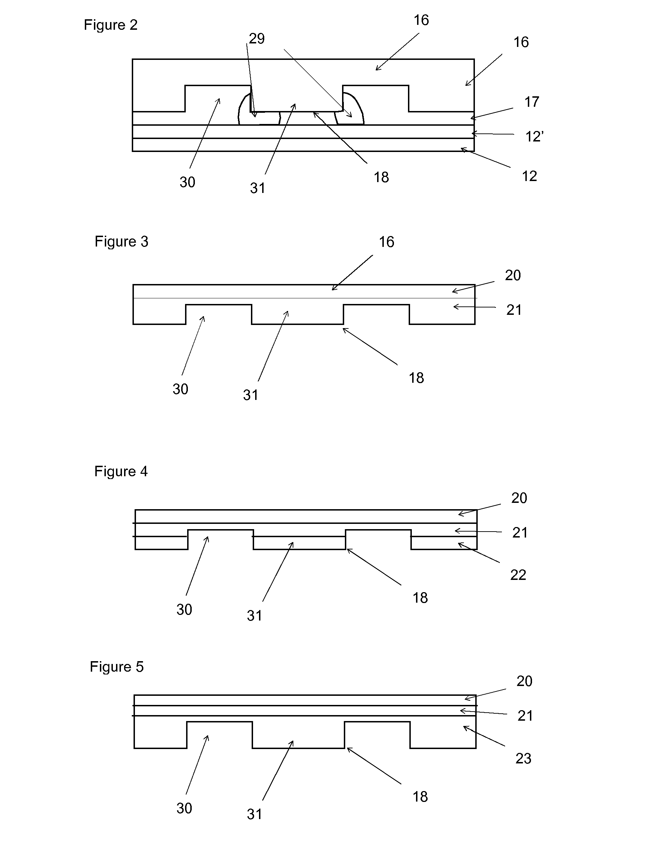

In Figure 2, an embodiment of UV imprint lithography is shown, as detailed above for Figure 1b. The imprint template 16 has contacted the imprintable medium 17 in a helium atmosphere. It can be seen that gas pockets 29 of helium have been formed between the patterned surface 18 and the imprintable medium 17 / substrate transfer layer 12' / substrate 12. When the imprintable medium is hardened, by shining UV radiation through the template 16, these gas pockets may lead to imperfections in the patterned, imprintable medium which may lead to corresponding imperfections in the subsequently patterned substrate 12 and/or transfer layer 12'.

Figure 3 shows schematically an imprint template according to an embodiment of the invention. The imprint template 16 has a substantially non-porous solid layer 20 of, for example, solid quartz and a layer of porous solid medium 21 in the form of, for example, a nanoporous silica layer. The protrusions 31 and recesses 30 of the patterned surface 18 of the imprint template 16 are formed entirely in the layer of porous solid medium 21.

In use, the patterned surface 18 contacts an imprintable medium 17 on a substrate 12 in a helium atmosphere as shown in Figure 2. Gas pockets 29 of helium form in the recesses 30. The pressure in the gas pockets 29 is higher than the pressure in the void space of the porous solid medium 21 and so the helium is rapidly driven into the void space by the pressure difference, by flow and/or diffusion. As a result, the gas pockets 29 will have substantially disappeared prior to hardening of the imprintable medium 17 by shining UV through the imprint template 16, meaning that imperfections in the patterned imprintable medium 17, and the subsequently patterned substrate 12, should be reduced. Both the solid quartz layer 20 and the porous solid medium 21 are substantially transmissive to UV. In this embodiment, the layer of porous solid medium 21 forms the patterned surface 18.

Figure 4 shows schematically an imprint template according to a further embodiment of the invention. The imprint template 16 has two layers of a substantially non-porous solid 20 and 22 (e.g., each of quartz) sandwiching a layer of porous solid medium 21 (e.g., nanoporous silica layer). The protrusions 31 and recesses 30 of the patterned surface 18 of the imprint template 16 extend from the solid layer 22 into or up to the solid medium 21.

In use, the patterned surface 18 contacts an imprintable medium 17 on a substrate 12 in a helium atmosphere as shown in Figure 2. Gas pockets 29 of helium form in the recesses 30. The pressure in the gas pockets 29 is higher than the pressure in the void space of the porous solid medium 21 and so the helium is rapidly driven into the void space by the pressure difference, by flow and/or diffusion. The helium may then flow/diffuse through the void space of the layer of porous solid medium 21 to escape to the ambient atmosphere at the edge of the layer. As a result, the gas pockets 29 will have substantially disappeared prior to hardening of the imprintable medium 17 by shining UV through the imprint template 16, more rapidly than in the prior art, meaning that less time is needed to avoid imperfections in the patterned imprintable medium 17, and the subsequently patterned substrate 12. In this embodiment, the layer of porous solid medium 21 forms patterning features of the patterned surface 18 of the imprint template 16; specifically it forms at least the ends of the recesses 30. The solid layer 22 should give improved mechanical strength to the patterned surface 18 compared to that of the embodiment of Figure 3, while maintaining excellent fluid and/or diffusive connection between the void space of the porous solid medium 21 and ends of the recesses 30 where a gas pocket 29 may form.

Figure 5 shows schematically an imprint template according to a further embodiment of the invention. The imprint template 16 has two layers of a substantially non-porous solid 20 and 23 (e.g., each of quartz) sandwiching a layer of porous solid medium 21 (e.g., nanoporous silica layer). The protrusions 31 and recesses 30 of the patterned surface 18 of the imprint template 16 extend solely into the solid layer 23, and not into the solid medium 21. This leads to a thin layer of solid 23 located between the recess ends 30 and the void space of the layer of porous solid medium 21.

In use, the patterned surface 18 contacts an imprintable medium 17 on a substrate 12 in a helium atmosphere as shown in Figure 2. Gas pockets 29 of helium form in the recesses 30. The pressure in the gas pockets 29 is higher than the pressure in the void space of the porous solid medium 21 and so the helium is rapidly driven into the void space by the pressure difference, by diffusion through the thin layer of solid 23 at the ends of the recesses 30. The helium may then flow/diffuse through the void space of the layer of porous solid medium 21 to escape to the ambient atmosphere at the edge of the layer. As a result, the gas pockets 29 will have substantially disappeared prior to hardening of the imprintable medium 17 by shining UV through the imprint template 16, more rapidly than in the prior art, meaning that less time is needed to avoid imperfections in the patterned imprintable medium 17, and the subsequently patterned substrate 12. In this embodiment, the layer of porous solid medium 21 does not form patterning features of the patterned surface 18 of the imprint template 16. This leads to improved mechanical strength but at the expense of a longer time for the helium to move into the void space of the porous solid medium 21.

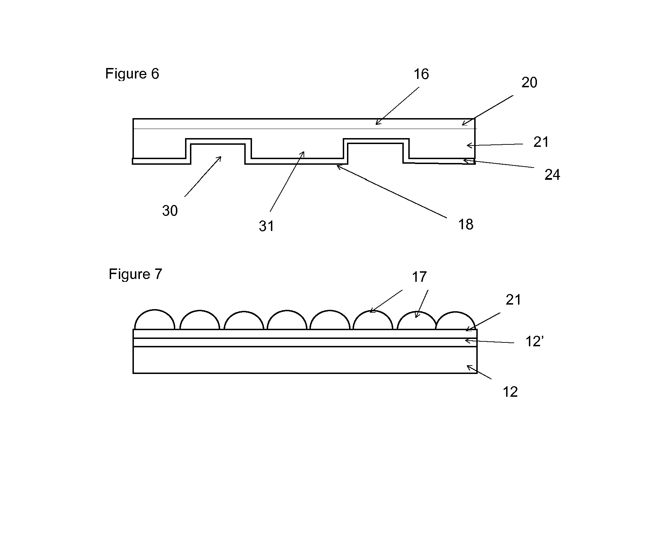

Figure 6 shows schematically an imprint template according to a further embodiment of the invention. The imprint template 16 has two layers of substantially non-porous solid 20 and 24 (e.g., each of quartz) sandwiching a layer of porous solid medium 21 (e.g., nanoporous silica layer). The protrusions 31 and recesses 30 of the patterned surface 18 of the imprint template 16 are at least partly formed in the porous solid medium 21, but are coated with a thin layer of solid (e.g., quartz) 24. This leads to a thin layer of solid 24 located between the patterning surface 18 and the void space of the layer of porous solid medium 21.

In use, the patterned surface 18 contacts an imprintable medium 17 on a substrate 12 in a helium atmosphere as shown in Figure 2. Gas pockets 29 of helium form in the recesses 30. The pressure in the gas pockets 29 is higher than the pressure in the void space of the porous solid medium 21 and so the helium is rapidly driven into the void space by the pressure difference, by diffusion through the thin layer of solid 24. The helium may then flow/diffuse through the void space of the layer of porous solid medium 21 to escape to the ambient atmosphere at the edge of the layer. As a result, the gas pockets 29 will have substantially disappeared prior to hardening of the imprintable medium 17 by shining UV through the imprint template 16, more rapidly than in the prior art, meaning that less time is needed to avoid imperfections in the patterned imprintable medium 17, and the subsequently patterned substrate 12. In this embodiment, the layer of porous solid medium 21 does not come into contact with the imprintable medium although it does form patterning features of the patterned surface 18 of the imprint template 16. Again this leads to improved mechanical strength compared to the embodiment of Figure 4 but at the expense of a longer time for the helium to move into the void space of the porous solid medium 21.

Figure 7 shows schematically a substrate according to an embodiment of the invention. Figure 7 shows the substrate 12 having a planarization/transfer layer 12' on top of which is a layer of porous solid medium 21 (e.g., of nanoporous silica). In Figure 7, droplets of imprintable, UV-hardenable material 17 are shown sitting on the porous solid medium 21 prior to contact with a patterning surface 18 of an imprint template 16.

In use, the substrate of Figure 7 may be used with any imprint template, including without limitation the template of any of Figures 2-6. Use with the imprint template of Figure 2 is described here as an example. The patterned surface 18 of the imprint template contacts the drops of imprintable medium 17 on the substrate 12 in a helium atmosphere, as shown in Figure 2. Gas pockets 29 of helium may be formed in the recesses 30. The pressure in the gas pockets 29 may be higher than the pressure in the void space of the porous solid medium 21 in the substrate and so the helium should be rapidly driven into the void space by the pressure difference, by dissolution into the imprintable medium 17 and subsequent diffusion through the imprintable medium to the porous layer 21 of the substrate. Gas in the void space of the porous layer 12 may escape to the ambient atmosphere at the edge of the substrate 12 by flowing/diffusing through the void space of the porous layer 21. As a result, the gas pockets 29 will have substantially disappeared prior to hardening of the imprintable medium 17 by shining UV through the imprint template 16 meaning that less time is needed to avoid imperfections in the patterned imprintable medium 17, and the subsequently patterned substrate 12.

It will be appreciated that numerous modifications to the above described embodiments may be made without departing from the scope of the invention as defined in the appended claims. For example, the imprinting method used may be a hot embossing process as shown in Figure 1a rather than the UV imprint method detailed for the various embodiments above.

The term porous solid medium in this specification is meant to include any suitable porous solid having a void space suitable to hold or transfer gas. Typically, a porous solid medium is characterized by pore volume and by mean pore diameter. There may be a distribution of pore sizes present in the medium.

For the purposes herein, pore diameters are desired such that the imprintable medium does not substantially flow into the pores under the pressure resulting from contacting the imprint template and the imprintable medium together. For this reason, a so-called nanoporous material may be used, such as a nanoporous ceramic. It may be desirable to use a closed pore structure for the porous solid medium for this reason.

An example porous solid medium is silica, particularly nanoporous silica. A suitable method for preparing a layer of nanoporous silica is described in, for example, European patent application publication nos. EP-A-1 818 583, EP-A-0 775 669, EP-A-0 775 669, EP-A-1 037 276 and EP-A-1 169 491.

Typically, a layer of porous solid medium, such as nanoporous silica, may be formed by a sol-gel process as known in the art where solvent is evaporated from a gel such as a silica gel in order to form a porous solid. Other suitable routes include chemical vapor deposition of a porous layer, or a spin-on glass process, all as mentioned hereinbefore. Suitably, a porous layer may be formed by thermal processing of a hydrophilic silanol or a mixture of silanol and siloxane coating into hydrophobic silicon-oxide containing layer by heating at say 600-700°C. Such a porous layer is of particular use with an apolar or hydrophobic imprintable medium.

As a porous or nanoporous solid medium such as silica may be less mechanically strong than corresponding non-porous solid medium such as quartz, it may be advantageous to cap a porous or nanoporous medium such as silica with a thin non-porous solid layer such as quartz as explained hereinbefore. Furthermore, such a non-porous solid layer may be of use to prevent resist from flowing into the pores of the porous solid medium. For layers formed by a sol-gel process, layer thickness may be limited due to mechanical stresses caused by evaporation. To improve strength, alternating layers of porous and non-porous solid medium may be employed. Layers of solid quartz less than 1 µm in thickness are sufficiently permeable to gases such as helium for diffusion into porous solid layers to occur.

When a nanoporous silica forms part, or all, of the patterned surface of the imprint template, the release of the patterned surface from the hardened imprintable medium may be facilitated by replacing some or all of the silicon in the porous silica layer by titanium, aluminium or tantalum.

Typically, the thickness of a nanoporous solid layer, such as a nanoporous silica layer for use with the invention will be from 1 to 10 µm, preferably from 3 to 8 µm such as approximately 5 µm. The porosity of the nanoporous solid layer will typically be from 0.1 to 5% by volume, suitably from 0.5 to 2%, such as about 1%.

By "transmissive" to actinic radiation such as UV, it is meant in this specification that a material transmissive to UV allows a substantial portion of UV falling upon it to pass through it without a substantial loss in intensity. Suitably, a 1mm layer of a transmissive material will allow at least 10% of the UV power falling upon it at a specified wavelength to pass through it, preferably at least 30%.

The described and illustrated embodiments are to be considered as illustrative and not restrictive in character, it being understood that only the preferred embodiments have been shown and described and that all changes and modifications that come within the scope of the inventions as defined in the claims are desired to be protected. It should be understood that while the use of words such as "preferable", "preferably", "preferred" or "more preferred" in the description suggest that a feature so described may be desirable, it may nevertheless not be necessary and embodiments lacking such a feature may be contemplated as within the scope of the invention as defined in the appended claims. In relation to the claims, it is intended that when words such as "a," "an," "at least one," or "at least one portion" are used to preface a feature there is no intention to limit the claim to only one such feature unless specifically stated to the contrary in the claim. When the language "at least a portion" and/or "a portion" is used the item can include a portion and/or the entire item unless specifically stated to the contrary.

Other aspects of the invention are set out as in the following numbered clauses:
1. A method for patterning an imprintable medium on a substrate by means of an imprint template having a patterned surface, the method comprising:
   contacting the patterned surface and the imprintable medium in the presence of a gas;
   hardening the imprintable medium; and
   separating the patterned surface and the imprintable medium,
   wherein trapped gas between the patterned surface and the substrate and/or imprintable medium, escapes to a void space, configured to permit escape of the trapped gas, prior to separating the patterned surface and the imprintable medium.
2. The method of clause 1, wherein the imprintable medium is hardened prior to separating the patterned surface and the imprintable medium.
3. The method of clause 1 or clause 2, wherein the imprint template comprises the void space.
4. The method of any preceding clause, wherein the void space is a void space of a porous solid medium.
5. The method of clause 4, wherein the imprint template comprises a layer of porous solid medium.
6. The method of clause 5, wherein the layer of porous solid medium forms patterning features of the patterned surface of the imprint template.
7. The method of clause 6, wherein the layer of porous solid medium forms the patterned surface of the imprint template.
8. The method of any one of clauses 4 to 7, wherein the porous solid medium is a region within the imprint template having a void space configured to be in diffusive and/or fluid connection with the trapped gas.
9. The method of any one of clauses 4 to 8, wherein the porous solid medium is transmissive to UV radiation.
10. The method of any one of clauses 4 to 9, wherein the porous solid medium is selected from the group consisting of silica, silicon nitride, titania, tin oxide, zirconia, alumina, tantalum oxide, and any mixture thereof.
11. The method of clause 10, wherein the porous solid medium comprises or is a silica, optionally a nanoporous silica.
12. The method of any preceding clause, wherein the patterned surface comprises a release layer comprising or consisting essentially of titania, alumina, tantalum oxide, or any mixture thereof.
13. The method of clause 1 or clause 2, wherein the substrate comprises the void space.
14. The method of clause 13, wherein the void space is a void space of a layer of porous solid medium.
15. The method of clause 14, wherein the layer of porous solid medium forms a surface of the substrate in contact with the imprintable medium.
16. The method of any preceding clause, wherein the imprintable medium is hardened by UV radiation applied through the imprint template.
17. An apparatus for imprint lithography of a substrate, the apparatus comprising:
   an imprint template comprising a void space and having a patterned surface arranged to pattern an imprintable medium on a substrate by contacting the patterned surface and the imprintable medium, wherein the void space is in diffusive and/or fluid connection with the patterned surface such that a gas trapped between the patterned surface and the substrate and/or imprintable medium can escape into the void space while the patterned surface and the imprintable medium are in contact.
18. The apparatus of clause 17, wherein the void space is a void space of a layer of porous solid medium.
19. The apparatus of clause 18, wherein the layer of porous solid medium forms at least part of the patterned surface.
20. The apparatus of clause 18, wherein the porous solid medium forms the patterned surface.
21. The apparatus of clause 18, wherein the pattern features are not in direct fluid connection with the void space such that the gas escape into the void space is by diffusion.
22. The apparatus of clause 21, wherein a layer of substantially non-porous solid adjacent to the layer of porous solid medium forms the patterned surface.
23. The apparatus of any one of clauses 17 to 22, wherein the imprint template is configured to allow UV radiation to pass through the imprint template onto the imprintable medium while the patterned surface and the imprintable medium are in contact.
24. The apparatus of any one of clauses 17 to 23, wherein the porous solid medium is selected from the group consisting of silica, silicon nitride, titania, tin oxide, zirconia, alumina, tantalum oxide, and any mixture thereof.
25. The apparatus of clause 24, wherein the porous solid medium comprises or is a silica, optionally a nanoporous silica.
26. The apparatus of any one of clauses 17 to 25, wherein the patterned surface comprises a release layer comprising or consisting essentially of titania, alumina, tantalum oxide or any mixture thereof.
27. An imprint template for imprint lithography of a substrate, the imprint template comprising a void space and having a patterned surface arranged to pattern an imprintable medium on a substrate by contacting the patterned surface and the imprintable medium, wherein the void space is in diffusive and/or fluid connection with the patterned surface such that a trapped gas, trapped between the patterned surface and the substrate and/or imprintable medium, may escape into the void space while the patterned surface and the imprintable medium are in contact.
28. The imprint template of clause 27, wherein the void space is a void space of a layer of porous solid medium.
29. A method for manufacturing an imprint template according to clause 28 wherein the layer of porous solid medium is formed by a plasma deposition process.
30. A method for manufacturing an imprint template according to clause 28 wherein the layer of porous solid medium is formed by a spun-on-glass process.
31. A method for manufacturing an imprint template according to clause 28 wherein the layer of porous solid medium is formed by a sol-gel deposition process.
32. The method of clause 31, wherein the porous solid medium is patterned as a gel, when in its gel state, by pressing a master template and the gel together prior to solidification of the gel.
33. The method of any one of clauses 29 to 32, wherein the porous solid medium comprises or consists essentially of silica, optionally nanoporous silica.
34. A substrate adapted to be patterned by imprint lithography, the substrate comprising a void space in diffusive and/or fluid connection with a surface of the substrate adapted to be patterned.
35. The substrate of clause 34, wherein the void space is a void space of a layer of porous solid medium on the surface adapted to be patterned.
36. The substrate of clause 34 or clause 35, wherein the porous solid medium comprises or consists essentially of a silica, optionally a nanoporous silica.

## Claims

1. A method for patterning an imprintable medium (17) on a substrate (12) by means of an imprint template (16) having a patterned surface (18), the method comprising:
contacting the patterned surface (18) and the imprintable medium (17) in the presence of a gas;
hardening the imprintable medium (17); and
separating the patterned surface (18) and the imprintable medium (17),
wherein trapped gas between the patterned surface (18) and the substrate (12) and/or imprintable medium (17), escapes to a void space of a nanoporous solid medium (21), configured to permit escape of the trapped gas, prior to separating the patterned surface (18) and the imprintable medium (17);
wherein the imprintable medium (17) is hardened prior to separating the patterned surface (18) and the imprintable medium (17);
wherein the imprint template (16) comprises the void space; and
**characterized in that**
the patterned surface (18) comprises a release layer comprising or consisting essentially of titania, alumina, tantalum oxide, or any mixture thereof.

2. The method of claim 1, wherein the imprint template (16) comprises a layer of nanoporous solid medium (21).

3. The method of claim 1 or 2, wherein the nanoporous solid medium (21) is a region within the imprint template (16) having a void space configured to be in diffusive and/or fluid connection with the trapped gas.

4. The method of any preceding claim, further comprising aligning a pattern with a previously provided pattern and/or with alignment marks provided on the substrate (12).

5. The method of any preceding claim, further comprising after separating the patterned surface (18) and the imprintable medium (17), etching the patterned imprintable medium (17).

6. The method of any preceding claim, wherein the method is a step and flash imprint lithography method.

7. An apparatus for imprint lithography of a substrate (12), the apparatus comprising:
an imprint template (16) comprising a void space of a layer of nanoporous solid medium (21) and having a patterned surface (18) arranged to pattern an imprintable medium (17) on a substrate (12) by contacting the patterned surface (18) and the imprintable medium (17), wherein the void space of the layer of nanoporous solid medium (21) is in diffusive and/or fluid connection with the patterned surface (18) such that a gas trapped between the patterned surface (18) and the substrate (12) and/or imprintable medium (17) can escape into the void space of the layer of nanoporous solid medium (21) while the patterned surface (18) and the imprintable medium (17) are in contact; and
**characterized in that**
the patterned surface (18) comprises a release layer comprising or consisting essentially of titania, alumina, tantalum oxide or any mixture thereof.

8. The apparatus of claim 7, further comprising an alignment apparatus configured to align a pattern with a previously provided pattern, and/or with alignment marks provided on the substrate (12).

9. The apparatus of any one of claims 7 to 8, wherein the apparatus is configured for step and flash imprint lithography.

10. An imprint template (16) for imprint lithography of a substrate (12), the imprint template (16) comprising a void space of a layer of nanoporous solid medium (21) and having a patterned surface (18) arranged to pattern an imprintable medium (17) on a substrate (12) by contacting the patterned surface (18) and the imprintable medium (17), wherein the void space of the layer of nanoporous solid medium (21) is in diffusive and/or fluid connection with the patterned surface (18) such that a trapped gas, trapped between the patterned surface (18) and the substrate (12) and/or imprintable medium (17), may escape into the void space of the layer of nanoporous solid medium (21) while the patterned surface (18) and the imprintable medium (17) are in contact, **characterized in that**
the porosity of the nanoporous solid layer is from 0.5 to 2 % by volume.

## Patentansprüche

1. Ein Verfahren zum Mustern eines prägbaren Mediums (17) auf einem Substrat (12) mittels einer Prägeschablone (16) mit einer gemusterten Oberfläche (18), wobei das Verfahren Folgendes beinhaltet:
In-Kontakt-Bringen der gemusterten Oberfläche (18) und des prägbaren Mediums (17) in Gegenwart eines Gases;
Härten des prägbaren Mediums (17); und
Separieren der gemusterten Oberfläche (18) und des prägbaren Mediums (17),
wobei zwischen der gemusterten Oberfläche (18) und dem Substrat (12) und/oder dem prägbaren Medium (17) eingeschlossenes Gas in einen Hohlraum eines nanoporösen festen Mediums (21), der konfiguriert ist, um das Entweichen des eingeschlossenen Gases zu gestatten, entweicht, bevor die gemusterte Oberfläche (18) und das prägbare Medium (17) separiert werden;
wobei das prägbare Medium (17) vor dem Separieren der gemusterten Oberfläche (18) und des prägbaren Mediums (17) gehärtet wird;
wobei die Prägeschablone (16) den Hohlraum beinhaltet; und
**dadurch gekennzeichnet ist, dass** die gemusterte Oberfläche (18) eine Trennschicht beinhaltet, die Titandioxid, Aluminiumoxid, Tantaloxid oder eine beliebige Mischung davon beinhaltet oder im Wesentlichen daraus besteht.

2. Verfahren gemäß Anspruch 1, wobei die Prägeschablone (16) eine Schicht aus nanoporösem festem Medium (21) beinhaltet.

3. Verfahren gemäß Anspruch 1 oder 2, wobei das nanoporöse feste Medium (21) eine Region innerhalb der Prägeschablone (16) ist, die einen Hohlraum aufweist, der konfiguriert ist, um mit dem eingeschlossenen Gas in Diffusions- und/oder Fluidverbindung zu stehen.

4. Verfahren gemäß einem der vorhergehenden Ansprüche, das ferner das Justieren eines Musters nach einem zuvor bereitgestellten Muster und/oder nach Justiermarken, die auf dem Substrat (12) bereitgestellt sind, beinhaltet.

5. Verfahren gemäß einem der vorhergehenden Ansprüche, das ferner nach dem Separieren der gemusterten Oberfläche (18) und des prägbaren Mediums (17) das Ätzen des gemusterten prägbaren Mediums (17) beinhaltet.

6. Verfahren gemäß einem der vorhergehenden Ansprüche, wobei das Verfahren ein Step-and-Flash-Imprint-Lithographieverfahren ist.

7. Ein Gerät für die Prägelithografie eines Substrats (12), wobei das Gerät Folgendes beinhaltet:
eine Prägeschablone (16), die einen Hohlraum einer Schicht aus nanoporösem festem Medium (21) beinhaltet und eine gemusterte Oberfläche (18) aufweist, die eingerichtet ist, um ein prägbares Medium (17) auf einem Substrat (12) durch In-Kontakt-Bringen der gemusterten Oberfläche (18) und des prägbaren Mediums (17) zu mustern, wobei der Hohlraum der Schicht aus nanoporösem festem Medium (21) mit der gemusterten Oberfläche (18) in Diffusions- und/oder Fluidverbindung steht, so dass ein zwischen der gemusterten Oberfläche (18) und dem Substrat (12) und/oder dem prägbaren Medium (17) eingeschlossenes Gas in den Hohlraum der Schicht aus nanoporösem festem Medium (21) entweichen kann, während die gemusterte Oberfläche (18) und das prägbare Medium (17) in Kontakt stehen; und
**dadurch gekennzeichnet ist, dass** die gemusterte Oberfläche (18) eine Trennschicht beinhaltet, die Titandioxid, Aluminiumoxid, Tantaloxid oder eine beliebige Mischung davon beinhaltet oder im Wesentlichen daraus besteht.

8. Gerät gemäß Anspruch 7, das ferner einen Justiergerät beinhaltet, welches konfiguriert ist, um ein Muster nach einem zuvor bereitgestellten Muster und/oder nach Justiermarken, die auf dem Substrat (12) bereitgestellt sind, zu justieren.

9. Gerät gemäß einem der Ansprüche 7 bis 8, wobei das Gerät für die Step-and-Flash-Imprint-Lithographie konfiguriert ist.

10. Eine Prägeschablone (16) für die Prägelithografie eines Substrats (12), wobei die Prägeschablone (16) einen Hohlraum einer Schicht aus nanoporösem festem Medium (21) beinhaltet und eine gemusterte Oberfläche (18) aufweist, die eingerichtet ist, um ein prägbares Medium (17) auf einem Substrat (12) durch In-Kontakt-Bringen der gemusterten Oberfläche (18) und des prägbaren Mediums (17) zu mustern, wobei der Hohlraum der Schicht aus nanoporösem festem Medium (21) mit der gemusterten Oberfläche (18) in Diffusions- und/oder Fluidverbindung steht, so dass ein eingeschlossenes Gas, das zwischen der gemusterten Oberfläche (18) und dem Substrat (12) und/oder dem prägbaren Medium (17) eingeschlossen ist, in den Hohlraum der Schicht aus nanoporösem festem Medium (21) entweichen kann, während die gemusterte Oberfläche (18) und das prägbare Medium (17) in Kontakt stehen, **dadurch gekennzeichnet, dass** die Porosität der nanoporösen festen Schicht von 0,5 bis 2 Volumen-% beträgt.

## Revendications

1. Un procédé pour conformer selon un motif un support imprimable (17) sur un substrat (12) au moyen d'un gabarit d'impression (16) possédant une surface à motif (18), le procédé comprenant :
la mise en contact de la surface à motif (18) et du support imprimable (17) en présence d'un gaz ;
le durcissement du support imprimable (17) ; et
la séparation de la surface à motif (18) et du support imprimable (17),
dans lequel du gaz pris au piège entre la surface à motif (18) et le substrat (12) et/ou le support imprimable (17) s'échappe jusqu'à un espace vide d'un support solide nanoporeux (21), configuré afin de permettre au gaz pris au piège de s'échapper,
préalablement à la séparation de la surface à motif (18) et du support imprimable (17) ;
dans lequel le support imprimable (17) est durci préalablement à la séparation de la surface à motif (18) et du support imprimable (17) ;
dans lequel le gabarit d'impression (16) comprend l'espace vide ; et
**caractérisé en ce que** la surface à motif (18) comprend une couche démoulante comprenant ou consistant essentiellement en dioxyde de titane, alumine, oxyde de tantale, ou tout mélange de ceux-ci.

2. Le procédé de la revendication 1, dans lequel le gabarit d'impression (16) comprend une couche de support solide nanoporeux (21).

3. Le procédé de la revendication 1 ou de la revendication 2, dans lequel le support solide nanoporeux (21) est une région à l'intérieur du gabarit d'impression (16) possédant un espace vide configuré afin d'être en connexion diffusive et/ou fluidique avec le gaz pris au piège.

4. Le procédé de n'importe quelle revendication précédente, comprenant en sus l'alignement d'un motif avec un motif fourni au préalable et/ou avec des repères d'alignement fournis sur le substrat (12).

5. Le procédé de n'importe quelle revendication précédente, comprenant en sus après la séparation de la surface à motif (18) et du support imprimable (17), la gravure du support imprimable à motif (17).

6. Le procédé de n'importe quelle revendication précédente, le procédé étant un procédé de lithographie par impression « step and flash ».

7. Un appareil pour la lithographie par impression d'un substrat (12), l'appareil comprenant :
un gabarit d'impression (16) comprenant un espace vide d'une couche de support solide nanoporeux (21) et possédant une surface à motif (18) arrangée afin de conformer selon un motif un support imprimable (17) sur un substrat (12) par la mise en contact de la surface à motif (18) et du support imprimable (17), dans lequel l'espace vide de la couche de support solide nanoporeux (21) est en connexion diffusive et/ou fluidique avec la surface à motif (18) de telle sorte qu'un gaz pris au piège entre la surface à motif (18) et le substrat (12) et/ou le support imprimable (17) puisse s'échapper jusque dans l'espace vide de la couche de support solide nanoporeux (21) pendant que la surface à motif (18) et le support imprimable (17) sont en contact ; et
**caractérisé en ce que** la surface à motif (18) comprend une couche démoulante comprenant ou consistant essentiellement en dioxyde de titane, alumine, oxyde de tantale ou tout mélange de ceux-ci.

8. L'appareil de la revendication 7, comprenant en sus un appareil d'alignement configuré afin d'aligner un motif avec un motif fourni au préalable, et/ou avec des repères d'alignement fournis sur le substrat (12).

9. L'appareil de l'une quelconque des revendications 7 à 8, l'appareil étant configuré pour la lithographie par impression « step and flash ».

10. Un gabarit d'impression (16) pour la lithographie par impression d'un substrat (12), le gabarit d'impression (16) comprenant un espace vide d'une couche de support solide nanoporeux (21) et possédant une surface à motif (18) arrangée afin de conformer selon un motif un support imprimable (17) sur un substrat (12) par la mise en contact de la surface à motif (18) et du support imprimable (17), dans lequel l'espace vide de la couche de support solide nanoporeux (21) est en connexion diffusive et/ou fluidique avec la surface à motif (18) de telle sorte qu'un gaz pris au piège, piégé entre la surface à motif (18) et le substrat (12) et/ou le support imprimable (17), puisse s'échapper jusque dans l'espace vide de la couche de support solide nanoporeux (21) pendant que la surface à motif (18) et le support imprimable (17) sont en contact, **caractérisé en ce que** la porosité de la couche solide nanoporeuse est de 0,5 à 2 % par volume.
